# EUROPEAN PATENT APPLICATION

(11) **EP 1 156 582 A2**
(43) Date of publication of application: **21.11.2001**
(21) Application number: 01304258.5
(22) Date of filing: 14.05.2001
(51) Int. Cl.: H03F 1/56

(54) **Transmitter/receiver chain impedance optimization**

(30) Priority: 16.05.2000 US 571776
(71) Applicant: NOKIA MOBILE PHONES LTD., 02150 Espoo (FI)
(72) Inventor: Portin, Jyrki, Oulu (FI)
(74) Representative: Slingsby, Philip Roy

(57) **Abstract**

A radio frequency (RF) amplifier circuit includes an RF amplifier having an input for receiving an RF signal to be amplified and an output for outputting an amplified RF signal to a load. Coupled to the output of the RF amplifier, between the output and the load, there is provided a filter element having a controllable impedance. The filter element is separate from the RF amplifier, and has an input terminal for receiving the amplified RF signal, an output terminal for outputting a filtered RF signal to the load, and a control terminal for receiving a control signal. The filter element is responsive to the control signal for setting an impedance of the filter element accordingly. The impedance of the filter element is controlled for enhancing the efficiency of the RF amplifier when operating at an output power level that differs from a maximum design output power level. Also disclosed is a receive chain that includes an RF signal source having an output coupled, through a switchable impedance device, to an input of a first RF circuit in a first mode of operation and to an input of a second RF circuit in a second mode of operation.

## Description

This invention relates generally to radiotelephones and, in particular, to radiotelephones or mobile stations having transmitter or receiver circuits that are required to operate with different power levels.

During the use of mobile stations an important consideration is power amplifier efficiency. For a fixed power amplifier voltage supply, the output power is determined by the operating load line. However, power amplifiers will experience a reduction in efficiency when operated at output power levels below some predetermined peak output power operating point.

Also, in some receiver circuit applications it is desirable to change the input/output impedance. For example, the mobile station may include a dual mode capable integrated circuit(s), where parallel analog and digital amplifiers and mixers are switched on and off in different operational modes. In many cases this type of operation requires different input/output impedances to optimize the receiver gain and sensitivity performance.

One purported solution to such problems is presented in U.S. Patent No.: 5,276,912, issued January 4, 1994 to Siwiak et al., and entitled "Radio Frequency Power Amplifier Having Variable Output Power". In this approach an RF amplifier is constructed to include a controllable impedance transformation network. The transformation network operates to transform the impedance of the amplifier load to a transformed impedance at the output of the amplifier. It is said that as a result the efficiency of the RF amplifier is not substantially degraded as the power level for the output signal is changed.

A different approach is proposed in U.S. Patent No.: 5,541,554, issued on July 30, 1996 to Stengel et al., entitled "Multi-Mode Power Amplifier", wherein a power amplifier has at least two amplification gain paths coupled in parallel to an input portion of the amplifier. The outputs are combined at a common node, and an impedance transformation network is provided between the output node and an active amplification component in at least one of the gain paths. Means are provided for switching a particular gain path out of the amplifier.

These approaches have a common disadvantage that they require the amplifier efficiency improvement circuitry to be incorporated into the RF power amplifier design itself, and furthermore require additional components to be added to the amplifier circuitry. Another disadvantage is that poor impedance matching and reflections can exist between the output of the RF power amplifier and an output component, such as a duplexer, filter, or transmit/receive (T/R) switch. If severe, the impedance mismatch and reflections can damage the amplifier, or at least degrade its efficiency when operating in different transmit modes (e.g., linear/nonlinear, linear/more linear).

It is a first object and advantage of this invention to provide an improved technique to enhance the efficiency of an RF amplifier, particularly when operating at lower output power levels.

It is another object and advantage of this invention to provide an improved technique to enhance the efficiency of an RF amplifier by providing a tunable or switchable filter element that is separate from the RF amplifier and coupled to an output thereof, whereby the impedance of the filter element is controlled for optimizing the efficiency of the RF amplifier.

It is another object and advantage of this invention to improve the efficiency of an RF amplifier by providing a tunable or switchable filter element incorporated into a duplexer filter, a stand-alone filter, or a T/R switch that is separate from the RF amplifier and coupled to an output thereof.

It is a further object and advantage of this invention to reduce impedance mismatch and reflections between an output of an RF amplifier and a separate filter by providing the filter as a tunable or switchable filter element that is incorporated into a duplexer filter, a stand-alone filter, such as a low pass filter, or a T/R switch.

It is a further object and advantage of this invention to reduce impedance mismatch and reflections between an input and/or an output of an RF amplifier/mixer in a receive chain in two (or more) operational modes, when there exist parallel switched RF blocks with different input/output impedances.

The foregoing and other problems are overcome and the objects and advantages are realized by a mobile station that is constructed and operated in accordance with the teachings of this invention.

This invention teaches a lower cost, lower component count RF transmitter or receiver circuit, having an RF amplifier with improved efficiency, by providing a tunable or switchable filter element that is separate from the RF amplifier and that is coupled to an output thereof. The impedance of the filter element is controlled for optimizing the efficiency of the RF amplifier, particularly when operating at lower output power levels than the maximum design output power level. The controlled impedance filter element is preferably implemented as a tunable or switchable filter element that is incorporated into a duplexer filter, a stand-alone filter such as a low pass filter, or a T/R switch module that is separate from the RF amplifier and coupled to an output thereof. These teachings also serve to reduce impedance mismatch and reflections between the output of the RF amplifier and the separate tunable or switchable filter element.

A radio frequency (RF) amplifier circuit is thus disclosed to have an RF amplifier having an input for receiving an RF signal to be amplified and an output for outputting an amplified RF signal to a load and, coupled to the output of the RF amplifier between the output and the load, there is provided a filter element having a controllable impedance. The filter element is separate from the RF amplifier, and has an input terminal for receiving the amplified RF signal, an output terminal for outputting a filtered RF signal to the load, and a control terminal for receiving a control signal. The filter element is responsive to the control signal for setting an impedance of the filter element accordingly. The impedance of the filter element is controlled for enhancing the efficiency of the RF amplifier when operating at an output power level that differs from a maximum design output power level.

The filter element having the controllable impedance can form a portion of a duplexer, a stand-alone filter, or a transmit/receive (T/R) switch module.

In one embodiment the filter element having the controllable impedance includes a plurality of discrete filter elements each having a characteristic impedance, and further includes a switching network that is responsive to the control signal for selectively coupling and decoupling individual ones of the plurality of discrete filter elements between the input terminal and the output terminal.

In another embodiment the filter element having the controllable impedance includes a discrete filter element having a characteristic impedance, and a stripline matching element that is selectively electrically coupled and decoupled to the discrete filter element through a switch that is responsive to the control signal. When the stripline matching element is not electrically coupled to the discrete filter element the characteristic impedance differs from an impedance that is obtained by the discrete filter element when the stripline matching element is electrically coupled to the discrete filter element.

Also disclosed is a receive chain that includes an RF signal source having an output coupled, through a switchable impedance device, to an input of a first RF circuit in a first mode of operation and to an input of a second RF circuit in a second mode of operation. The switchable impedance device providing a first impedance when operating in said first mode of operation and providing a second, different impedance when operating in said second mode of operation, thereby reducing impedance mismatch and reflections.

In one embodiment the first RF circuit includes a first RF amplifier circuit and the second RF circuit includes a second RF amplifier circuit, where an input impedance of the first RF amplifier circuit differs from an input impedance of the second RF amplifier circuit. In this case the input impedance of the first RF amplifier circuit is approximately equal to the first impedance, and the input impedance of the second RF amplifier circuit is approximately equal to the second impedance.

In another embodiment the RF signal source can include an RF amplifier, the first RF circuit includes a first RF mixer circuit, and the second RF circuit includes a second RF mixer circuit. In this case the input impedance of the first RF mixer circuit may be approximately equal to the first impedance, and the input impedance of the second RF mixer circuit may be approximately equal to the second impedance.

The above set forth and other features of the invention are made more apparent in the ensuing Detailed Description of the Invention when read in conjunction with the attached Drawings, wherein:
Fig. 1 is a block diagram of a controlled impedance filter element in accordance with the teachings herein;
Fig. 2 shows the construction of the controlled impedance filter element of Fig. 1;
Fig. 3 shows an embodiment of the controlled impedance filter element when implemented within a T/R switch module; and
Figs. 4A and 4B depict the use of the switched impedance filter in a receive chain operation.

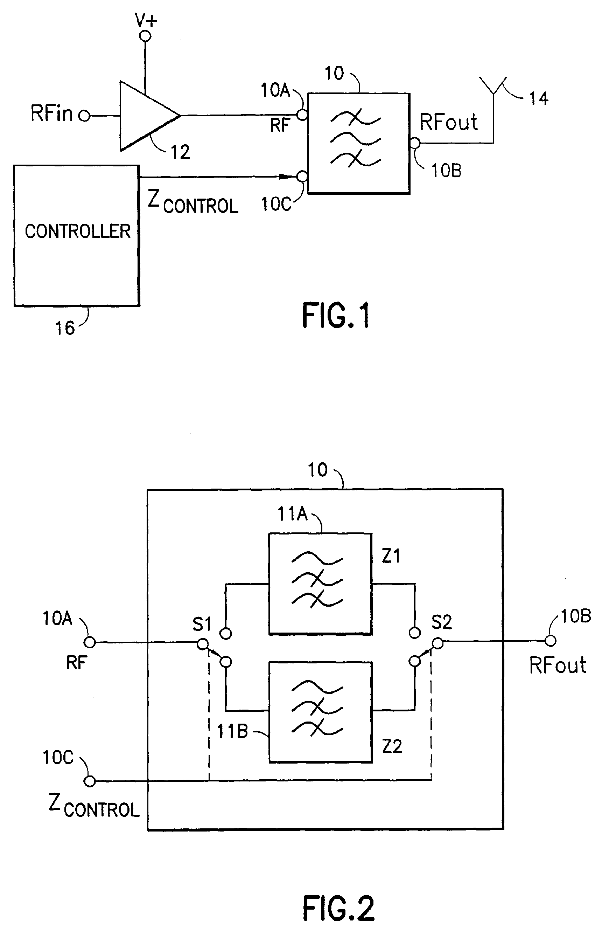

Reference is now made to Fig. 1 for illustrating a circuit diagram of an exemplary controlled impedance filter element 10 in accordance with the teachings of this invention. The filter element 10 may be considered as a three terminal device, wherein a first terminal 10A is an input terminal for receiving an output signal from an RF amplifier 12, a second terminal 10B is an output terminal for providing a filtered RF signal to a load, such as an antenna 14, and a third terminal 10C is an impedance control terminal for receiving a control signal (Z_{control}) from a controller 16. The controller 16 can be a control microprocessor of a radiotelephone, such as a cellular telephone or a personal communicator. It is assumed that the controller 16 also controls, or is at least aware of, the level of the input signal (RFᵢₙ) to the RF amplifier 12, and thus sets the control signal at control input 10C accordingly. In these teachings it is assumed that the RF amplifier 12 operates with a substantially constant supply voltage (V+), and is thus subject to reductions in efficiency when a reduction in the input drive signal RFᵢₙ causes a change in the operating point away from the optimum maximum design operating point.

It should be realized that the controlled impedance filter element 10 can be a stand-alone filter interposed between the output of the RF amplifier 12 and the load, or it could be one half (i.e., the transmit half) of a duplexer filter.

It can plainly be seen that the controlled impedance filter element 10 is separate from the RF amplifier 12, and is coupled after any impedance transformation network that may be included within the RF amplifier 12, as discussed in the prior art implementation referred to above. That is, the functionality for enhancing the efficiency of the RF power amplifier 12 is placed at the load side, such as in a duplexer filter, and not in the power amplifier 12 per se.

Fig. 2 shows one embodiment of the construction of the filter 10 of Fig. 1. Two high pass filters 11A and 11B are provided, each having a selected impedance Z1 and Z2, respectively. Selection between filter 11A and 11B is made with switches S1 and S2, which are controlled by the state of Z_{control}. For example, when Z_{control} is low S1 and S2 are in the position shown, and connect filter 11B between input terminal 10A and output terminal 10B, while when Z_{control} is high S1 and S2 are in the opposite position to that shown, and connect filter 11A between input terminal 10A and output terminal 10B. In practice, switches S1 and S2 could be mechanical switches, transistor switches, PIN diode switches, etc.

In the manner depicted in Fig. 1 the impedance seen by the output of the RF amplifier 12 is varied between Z1 and Z2, and the efficiency of the RF amplifier 12 can thus be enhanced and improved. For example, when operating with a high drive signal, e.g., one that drives the amplifier 12 at or near to its maximum efficiency point, then Z1 may be switched in by the controller 16, while when operating with a reduced drive signal, e.g., one that drives the amplifier 12 at about one half of its maximum efficiency point, then Z2 may be switched in by the controller 16. Suitable impedance values for Z1 and Z2 are of course application specific. The various filters can be low pass, band pass, high pass, or any desired and suitable type.

Preferably the switching threshold between Z1 and Z2 is related to the maximum power levels of the cellular telephone or personal communicator. In a most preferred embodiment, the highest and second highest power levels employ Z1, while the remaining (lower) power levels employ Z2.

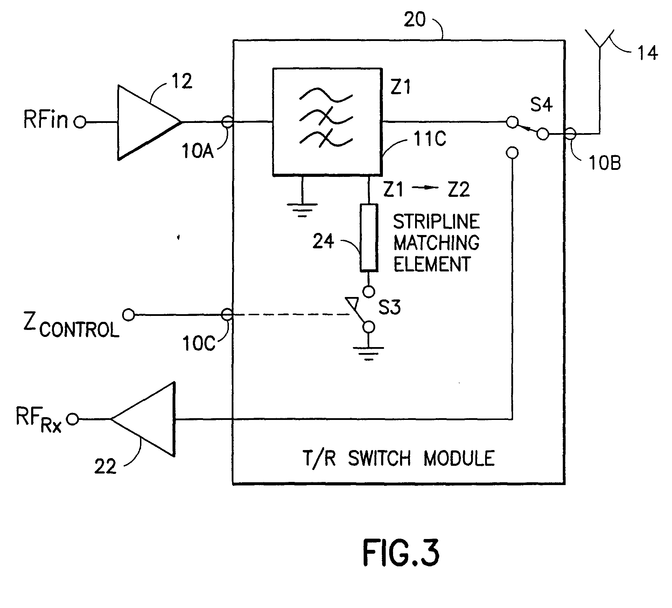

Note should be made that the impedance value may be changed as a function of modulation type as well, such as when employed in a dual mode (or higher) phone such as a GSM/EDGE phone, a TDMA/EDGE phone, a GSM/CDMA phone, etc. Fig. 3 shows an embodiment of this invention wherein a T/R switch module 20 has an additional output terminal for routing a received RF signal to an input of a receiver 22, via switch S4. In accordance with the teachings of this invention, the T/R switch module 20 includes a filter 11C having a tuneable impedance between Z1 and Z2. Tuning in this case is accomplished using a stripline matching element 24 that is selectively inserted or removed by switch S3, under the control of Z_{control}. For example, when operating at 1900 MHz the stripline matching element 24 has an impedance of about 10 ohms, and the filter impedance Z1 is tuned between about 50 ohms and about 10 ohms.

It should be apparent that the teachings found herein provide a lower cost, lower component count RF transmitter having an RF amplifier 12 with improved efficiency by providing the tunable or switchable filter element 10 that is separate from the RF amplifier 12, and that is coupled to the output of the amplifier 12 at the load. The impedance of the filter element 10 is controlled or switched for optimizing the efficiency of the RF amplifier 12, particularly when operating at a lower output power level than the maximum design output power level. The controlled impedance filter element 10 is preferably implemented as one or more tunable or switchable filter elements that are incorporated into, by example, a duplexer filter, a stand-alone filter, or the T/R switch 20 that is separate from the RF amplifier 12 and coupled to the output thereof. The teachings herein also serve to reduce the impedance mismatch and reflections between the output of the RF amplifier 12 and the input to the separate tunable or switchable filter element 10, thereby further enhancing the efficiency of the RF amplifier 12.

The teachings of this invention can be employed with single band, dual band, tri-band (and higher) radiotelephones, and can also be effective for RF amplifiers that are required to be selectively operated in different classes, as well as with different output power levels. The teachings of this invention can be employed with TDMA radiotelephones, CDMA radiotelephones, analog (FM) radiotelephones, and with radiotelephones capable of operation with two or more of these access methods.

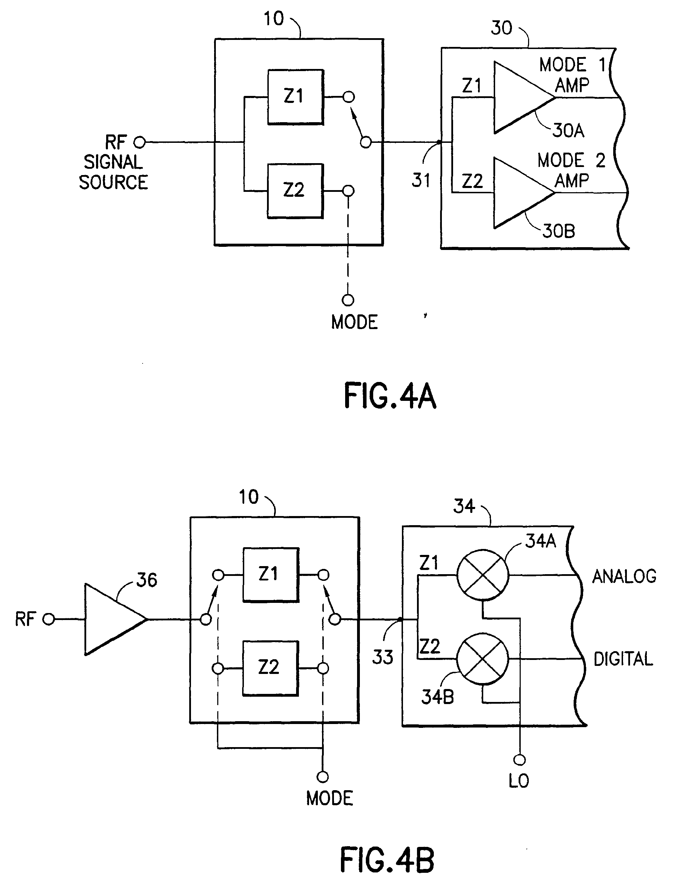

Fig. 4A shows the utility of this invention when operated in a receive chain. The controlled impedance filter element 10 has an output coupled to an input 31 of an integrated circuit (IC) 30 that contains a mode 1 amplifier 30A and a mode 2 amplifier 30B. The mode 1 amplifier 30A has a characteristic input impedance of Z1 and the mode 2 amplifier 30B has a characteristic input impedance of Z2. The controlled impedance filter element 10 is operated to couple Z1 to the input 31 of IC 30 when operating in mode 1, thereby matching the input impedance of amplifier 30A, and to couple Z2 to the input 31 of IC 30 when operating in mode 2, thereby matching the input impedance of amplifier 30B. It is assumed that the input of the mode 2 amplifier 30B has a high impedance when operating in mode 1, so as to negligibly load the output of the controlled impedance filter element 10.

Fig. 4B shows a case where the output of the controlled impedance filter element 10 is coupled to an input 33 of a dual mixer circuit 34 that contains, for example, an analog mode mixer 34A (e.g., one suitable for AMPS operation) and a digital mode mixer 34B (e.g., one suitable for GSM or CDMA operation). The mode signal is set accordingly so as to impedance match the amplifier 36 output to the input of the currently selected mixer 34A or 34B. The frequency of the local oscillator (LO) signal to the mixers 34A and 34B is set appropriately, depending on the operational mode.

In the receive chain these mixers 34A and 34B can be down-conversion mixers, whereas if employed in a transmit chain the mixers 34A and 34B could be up-conversion mixers.

Although described in the context of preferred embodiments, it should be realized that a number of modifications to these teachings may occur to one skilled in the art. By example, the teachings of this invention are not limited to only the specific frequencies or impedance values described above. Furthermore, the RF amplifier 12 could actually comprise a plurality of cascaded gain elements, and need not be implemented as a single amplifier as shown for simplicity in Figs. 1 and 3.

Also, while the invention has been described in the context of a variable impedance filter element that changes between Z1 and Z2, it is within the scope of this invention to arrange the control signal input so that the variable impedance filter element changes between Z1, Z2 and Z3, or Z1, Z2, Z3 and Z4, or in general between Z1 and Zn, where n is a positive integer. In this case the control signal Z_{control} could be an analog signal having various levels that are detected by a multi-level threshold comparator within the filter 10, or more than one signal line could be used in conjunction with a digital decoder within the filter element. For example, in this latter embodiment if Z_{control} is conveyed over three signal lines, then the impedance can be set to eight different values (2³). Furthermore, it should be appreciated that the switchable stripline matching technique shown in Fig. 3 could be used as well in the embodiment of Fig. 2 such that, for example, Z1 and Z2 are replaced with Z1 and the stripline matching element 24.

Thus, while the invention has been particularly shown and described with respect to preferred embodiments thereof, it will be understood by those skilled in the art that changes in form and details may be made therein without departing from the scope and spirit of the invention.

## Claims

1. A radio frequency (RF) amplifier circuit, comprising:
an RF amplifier having an input for receiving an RF signal to be amplified and an output for outputting an amplified RF signal to a load; and
coupled to said output of said RF amplifier between said output and said load, a filter element having a controllable impedance, said filter element being separate from said RF amplifier, said filter element having an input terminal for receiving the amplified RF signal, an output terminal for outputting a filtered RF signal to said load, and a control terminal for receiving a control signal, said filter element being responsive to said control signal for setting an impedance of said filter element accordingly, the impedance of said filter element being controlled for enhancing the efficiency of said RF amplifier when operating at an output power level that differs from a maximum design output power level.

2. A RF amplifier circuit as in claim 1, wherein said filter element having the controllable impedance comprises a portion of a duplexer.

3. A RF amplifier circuit as in claim 1, wherein said filter element having the controllable impedance comprises a portion of a stand-alone filter.

4. A RF amplifier circuit as in claim 1, wherein said filter element having the controllable impedance comprises a portion of a transmit/receive (T/R) switch module.

5. A RF amplifier circuit as in claim 1, wherein said filter element having the controllable impedance comprises a plurality of discrete filter elements each having a characteristic impedance, and switch means responsive to said control signal for selectively coupling and decoupling individual ones of said plurality of discrete filter elements between said input terminal and said output terminal.

6. A RF amplifier circuit as in claim 1, wherein said filter element having the controllable impedance comprises a discrete filter element having a characteristic impedance, a stripline matching element coupled to said discrete filter element, and switch means responsive to said control signal for selectively electrically coupling and decoupling said stripline matching element to said discrete filter element, wherein when said stripline matching element is not electrically coupled to said discrete filter element said characteristic impedance differs from an impedance that is obtained by said discrete filter element when said stripline matching element is electrically coupled to said discrete filter element.

7. A RF amplifier circuit as in claim 1, wherein said RF amplifier circuit forms a part of a radiotelephone.

8. A RF amplifier circuit as in claim 1, wherein said RF amplifier circuit forms a part of a dual mode or higher mode radiotelephone.

9. A RF amplifier circuit as in claim 1, wherein said RF amplifier circuit forms a part of a radiotelephone that operates in different frequency bands.

10. A RF amplifier circuit as in claim 1, wherein said RF amplifier circuit forms a part of a radiotelephone wherein said RF amplifier is required to operate in different amplifier classes.

11. A receive chain comprising an RF signal source having an output coupled, through a switchable impedance device, to an input of a first RF circuit in a first mode of operation and to an input of a second RF circuit in a second mode of operation, said switchable impedance device providing a first impedance when operating in said first mode of operation and providing a second, different impedance when operating in said second mode of operation.

12. A receive chain as in claim 11, wherein said first RF circuit comprises a first RF amplifier circuit and wherein said second RF circuit comprises a second RF amplifier circuit, wherein an input impedance of said first RF amplifier circuit differs from an input impedance of said second RF amplifier circuit.

13. A receive chain as in claim 12, wherein the input impedance of said first RF amplifier circuit is approximately equal to said first impedance, and wherein the input impedance of said second RF amplifier circuit is approximately equal to said second impedance.

14. A receive chain as in claim 11, wherein said RF signal source comprises an RF amplifier, wherein said first RF circuit comprises a first RF mixer circuit and wherein said second RF circuit comprises a second RF mixer circuit.

15. A receive chain as in claim 14, wherein an input impedance of said first RF mixer circuit is approximately equal to said first impedance, and wherein an input impedance of said second RF mixer circuit is approximately equal to said second impedance.

16. A method for operating an RF circuit, comprising steps of:
providing an RF signal source; and
switchably coupling an output of said RF signal source, through a switchable impedance device, to an input of a first RF circuit in a first operational mode and, in a second operational mode, to an input of a second RF circuit, the switchable impedance device providing a first impedance when operating in first operational mode and providing a second, different impedance when operating in the second operational mode.

17. A method for operating an RF amplifier circuit, comprising steps of:
providing an RF signal amplifier; and
switchably coupling an output of said RF signal amplifier source, through a switchable impedance device, to a load, wherein the switchable impedance device provides a first impedance when operating with a first RF signal amplifier output power level and provides a second, different impedance when operating with a second RF signal output power level.

18. A method for operating an RF amplifier circuit, comprising steps of:
providing an RF signal amplifier; and
switchably coupling an output of said RF signal amplifier source, through a switchable impedance device, to a load, wherein the switchable impedance device provides a first impedance when operating with a first type of RF signal modulation and provides a second, different impedance when operating with a second type of RF signal modulation.
